# EUROPÄISCHE PATENTANMELDUNG

(11) **EP 4 155 431 A1**
(43) Veröffentlichungstag der Anmeldung: **29.03.2023**
(21) Anmeldenummer: 22196460.4
(22) Anmeldetag: 20.09.2022
(51) Int. Cl.: C23C 28/02, C22C 19/00, C23C 14/02, C23C 14/14, C23C 16/02, C23C 16/06, C23C 30/00, C25D 7/00, B32B 15/01, F01D 5/28, F01D 25/00

(54) **VERFAHREN ZUR HERSTELLUNG UND ENTSPRECHEND HERGESTELLTES BAUTEIL AUS EINER NICKELBASISSUPERLEGIERUNG FÜR DEN HEISSGASKANAL EINER STRÖMUNGSMASCHINE**

(30) Priorität: 27.09.2021 DE 102021124859
(71) Anmelder: MTU Aero Engines AG, 80995 München (DE)
(72) Erfinder: Pillhöfer, Horst, 80995 München (DE); Hilser, Ludwig, 80995 München (DE); Dopfer, Manfred, 80995 München (DE); Waschka, Walter, 80995 München (DE); Schrade, Marcus, 80995 München (DE); Frommherz, Martin, 80995 München (DE)

(57) **Zusammenfassung**

Die vorliegende Erfindung betrifft ein Bauteil für den Heißgaskanal einer Strömungsmaschine, wobei das Bauteil aus einer Nickelbasissuperlegierung mit einer Schutzschicht gegen Oxidation und Heißgaskorrosion gebildet ist, und wobei die Schutzschicht γ - Nickel - Mischkristall - Phase aufweist und gemittelt über der Schutzschicht 45 bis 85 Gew.% Ni und 15 bis 55 Gew.% Cr umfasst sowie eine Dicke von 5 bis 80 µm aufweist. Die Erfindung betrifft weiterhin ein Verfahren zur Herstellung eines Bauteils aus einer Nickelbasissuperlegierung für den Heißgaskanal einer Strömungsmaschine, wobei das Verfahren die Schritte umfasst:
Bereitstellen eines Halbzeugs aus einer Nickelbasissuperlegierung,
Abscheiden von Ni und Cr oder Ni und Cr enthaltenden Legierungen oder Zusammensetzungen auf zumindest einem Teil des Halbzeugs durch chemische (CVD) oder physikalische (PVD) Dampfphasenabscheidung oder durch galvanische Abscheidung oder durch Streichen oder Lackieren zur Bildung einer Schutzschicht gegen Oxidation und Heißgaskorrosion und
Diffusionsglühen des Bauteils im Temperaturbereich zwischen 900° C und 1150° C für 1 bis 10 h.

## Beschreibung

### HINTERGRUND DER ERFINDUNG

### GEBIET DER ERFINDUNG

Die Erfindung betrifft ein Bauteil für den Heißgaskanal einer Strömungsmaschine, wobei das Bauteil aus einer Nickelbasissuperlegierung mit einer Schutzschicht gegen Oxidation und Heißgaskorrosion gebildet ist, sowie ein Verfahren zur Herstellung eines entsprechenden Bauteils aus einer Nickelbasissuperlegierung für den Heißgaskanal einer Strömungsmaschine.

### STAND DER TECHNIK

Strömungsmaschinen, wie Gasturbinen oder Flugtriebwerke, werden seit langem vielfältig eingesetzt. Durch die hohen thermischen und mechanischen Belastungen der darin verwendeten Bauteile bestehen besonders hohe Anforderungen hinsichtlich der mechanischen Eigenschaften und der Korrosions - und Oxidationsbeständigkeit an diese Bauteile. So werden beispielsweise für Lauf - und Leitschaufeln im Heißgaskanal von Strömungsmaschinen, wie beispielsweise im Bereich der Niederdruckturbine, Nickelbasis - Superlegierungen eingesetzt, die aufgrund ihrer Mikrostruktur hohen mechanischen Belastungen bei hohen Temperaturen ausgesetzt werden können.

Allerdings ist es weiterhin erstrebenswert eine Optimierung von entsprechenden Bauteilen dahingehend vorzunehmen, dass ein ausreichendes und ausgewogenes Eigenschaftsprofil hinsichtlich einer Vielzahl von unterschiedlichen, teilweise divergierenden Anforderungen erfüllt wird, wie beispielsweise einerseits hohe Festigkeit und Härte und insbesondere hohe Hochtemperaturfestigkeit zur Gewährleistung der hohen mechanischen Anforderungen und andererseits ausreichende Zähigkeit und Duktilität, um beispielsweise Schlagbelastungen zu überstehen und sprödes Bruchverhalten zu vermeiden. Dies gilt auch für Beschichtungen, die auf derartigen Bauteilen häufig aufgebracht sind, um eine ausreichende Korrosions - und Hochtemperaturoxidationsbeständigkeit zu erzielen.

Entsprechend ist in der US 2016/0 304 993 A1 ein System und ein Verfahren zur Herstellung von duktilen, nickelbasierten, austenitischen Beschichtungen beschrieben. Die entsprechenden Beschichtungen umfassen neben Nickel Chrom, Aluminium und Yttrium und weisen Schichtdicken im Bereich von 300 bis 500 µm auf. Die entsprechenden Schichten sind jedoch durch den komplexen Aufbau mit Chrom und Aluminium aufwändig in der Herstellung und die hohen Schichtdicken führen zudem zu einer Anfälligkeit für Schichtspannungen und der Gefahr von Abplatzungen der Schichten.

### OFFENBARUNG DER ERFINDUNG

### AUFGABE DER ERFINDUNG

Es ist deshalb Aufgabe der vorliegenden Erfindung ein Bauteil für die Verwendung im Heißgaskanal einer Strömungsmaschine bereitzustellen, welches ausgewogene mechanische und thermische Eigenschaften, wie Korrosions - und Hochtemperaturoxidationsbeständigkeit sowie Schwingungsfestigkeit, Kriechbeständigkeit und dergleichen aufweist. Ein entsprechendes Bauteil soll möglichst einfach herstellbar und zuverlässig in der Anwendung sein sowie eine hohe Lebensdauer aufweisen.

### TECHNISCHE LÖSUNG

Diese Aufgabe wird gelöst durch ein Bauteil für den Heißgaskanal einer Strömungsmaschine mit den Merkmalen des Anspruchs 1 sowie ein Verfahren zur Herstellung eines entsprechenden Bauteils mit den Merkmalen des Anspruchs 12. Vorteilhafte Ausgestaltungen sind Gegenstand der abhängigen Ansprüche.

Entsprechend schlägt die vorliegende Erfindung ein Bauteil für den Heißgaskanal einer Strömungsmaschine vor, welches aus einer Nickelbasissuperlegierung als Grundwerkstoff gebildet ist und mit einer Schutzschicht gegen Oxidation und Heißgaskorrosion versehen ist. Die Schutzschicht weist eine γ - Nickel - Mischkristall - Phase auf oder ist komplett aus dieser gebildet und umfasst gemittelt über der Schutzschicht 45 bis 85 Gew.% Ni und 15 bis 55 Gew.% Cr. Es hat sich gezeigt, dass für Anwendungen bei Dauereinsatztemperaturen bis 800° C mit kurzzeitigen Spitzenbelastungen bis 850° C, wie beispielsweise bei Laufschaufeln in der 2. und 3. Stufe einer Niederdruckturbine eines Flugtriebwerks kein Aluminium für die Korrosions - und Hochtemperaturoxidationsbeständigkeit anwesend sein muss und dass eine Dicke der Schutzschicht von 5 bis 80 µm ausreichend ist, um beispielsweise den Anforderungen hinsichtlich der Schwingfestigkeit, der Kriechbeständigkeit, der Schlagzähigkeit bei ausreichender Korrosions - und Hochtemperaturoxidationsbeständigkeit zu genügen. Damit ist eine einfachere Herstellung und Struktur der Schicht mit einer geringeren Gefahr von Schichtspannungen und Abplatzungen möglich.

Die Schutzschicht oder eine innere Teilschicht der Schutzschicht kann insbesondere 70 bis 85 Gew.% Ni und 15 bis 30 Gew.% Cr, vorzugsweise 75 bis 80 Gew. % Ni und 20 bis 25 Gew. % Cr umfassen, um duktile γ - Ni - Mischkristalle in der Schicht zu erzeugen, wobei der Chrom - Gehalt für die Korrosions - und Hochtemperaturbeständigkeit ausreichend ist. Bei den angegebenen Anteilen ergänzen sich Chrom und Nickel unter Berücksichtigung von unvermeidbaren Verunreinigungen zu 100%.

Umfasst die Schutzschicht neben unvermeidbaren Verunreinigungen neben Chrom und Nickel weitere Bestandteile bzw. Legierungselemente als Minoritätskomponenten, also insbesondere mit einem Anteil, der kleiner ist als der von Chrom oder der für die weiteren Komponenten jeweils einzeln oder in Summe weniger als 10 oder 5 Gew.% beträgt, so bleibt der Anteil von Chrom im angegebenen Bereich und der Rest wird durch Nickel gebildet. Allerdings kann weiterhin auf einen Anteil an Aluminium verzichtet werden.

Um die Korrosions - und Hochtemperaturbeständigkeit weiter zu verbessern, kann die Schutzschicht mindestens zwei Teilschichten aufweisen, wobei eine äußere Teilschicht einen höheren Chrom - Anteil und / oder auch Anteile an Aluminium aufweisen kann. So kann die Schutzschicht in einer äußeren Teilschicht über 40 Gew.% Cr und vorzugsweise bis zu 24 Gew.% Al, insbesondere bis zu 10 oder 15 Gew.% Al aufweisen, wobei der Rest neben unvermeidbaren Verunreinigungen wiederum durch Nickel oder durch Nickel und weitere Bestandteilen als Minoritätskomponenten gebildet werden kann.

Allerdings ist es auch weiterhin möglich, dass die Schutzschicht in einer inneren Teilschicht oder in der gesamten Schutzschicht überhaupt kein Aluminium aufweist.

Gemäß einer Ausführung wird zumindest in einer inneren Teilschicht der Schutzschicht auf einen Anteil an Aluminium verzichtet. Die Teilschicht kann insbesondere 70 bis 85 Gew.% Ni und 15 bis 30 Gew.% Cr, vorzugsweise 75 bis 80 Gew. % Ni und 20 bis 25 Gew. % Cr umfassen, insbesondere um duktile γ - Ni - Mischkristalle in der Schicht zu erzeugen, wobei sich bei den angegebenen Anteilen Chrom und Nickel unter Berücksichtigung von unvermeidbaren Verunreinigungen zu 100% ergänzen können.

Neben der inneren Teilschicht kann die Schutzschicht genau eine weitere (äußere) Teilschicht oder zwei oder mehr weitere Teilschichten umfassen.

Die auf der Nickelbasissuperlegierung des Bauteils gebildete Schutzschicht gegen Oxidation und Heißgaskorrosion ist vorzugsweise unmittelbar auf dem, insbesondere unbeschichteten, Grundwerkstoff des Bauteils, nämlich der Nickelbasissuperlegierung, ausgebildet und/oder kommt vorzugsweise bei der bestimmungsgemäßen Verwendung mit dem Heißgas in Kontakt bzw. ist diesem ausgesetzt, bildet also, insbesondere vollständig oder teilweise, eine bzw. die äußere Oberfläche des Bauteils.Die Schutzschicht kann eine mittlere Dicke von 15 bis 30 µm aufweist, wobei insbesondere eine äußere Teilschicht mit höherem Cr - Gehalt nur eine Dicke von bis zu 10 µm, insbesondere eine mittlere Dicke von 1 bis 3 µm aufweisen kann, sodass der Anteil der äußeren Teilschicht an der Gesamtschicht sehr klein ist und auch der komplexere Aufbau bei Anwesenheit von Aluminium nicht ins Gewicht fällt.

Die Schutzschicht kann in zumindest einer Teilschicht vollständig oder bei einschichtigem Aufbau insgesamt vollständig als kubisch flächenzentrierter γ - Nickel - Mischkristall ausgebildet sein, um die duktilen Eigenschaften der Schutzschicht für die Schlagzähigkeit zu gewährleisten. Darüber hinaus kann die Schutzschicht zumindest teilweise in einem kubisch raumzentrierten Metallgitter, vorzugsweise in zumindest einer Teilschicht zumindest teilweise als kubisch raumzentrierte α - Chrom - Phase ausgebildet sein, wenn der Chrom - Anteil erhöht werden soll, wie insbesondere in einer äußeren Teilschicht bei zweischichtigem Aufbau.

Folglich kann das Bauteil im Querschnitt von außen nach innen entweder eine Schutzschicht mit einer Teilschicht aus α - Chrom - Phase mit γ - Nickel - Mischkristall mit im Mischkristall aufgenommenem Chrom und / oder Aluminium und einer Teilschicht aus γ - Nickel - Mischkristall sowie eine anschließende Zone entsprechend der Nickelbasissuperlegierung mit einem kubisch-flächenzentriertem Ni - Mischkristall mit ausgeschiedenen kohärenten γ - Partikeln der Zusammensetzung Ni(Al,Ti)₃ aufweisen oder eine Schutzschicht aus γ - Nickel - Mischkristall mit im Mischkristall aufgenommenem Chrom sowie eine anschließende Zone entsprechend der Nickelbasissuperlegierung mit einem kubisch-flächenzentriertem Ni - Mischkristall mit ausgeschiedenen kohärenten γ - Partikeln der Zusammensetzung Ni(Al,Ti)₃.

Die Bruchdehnung einer derartigen Schutzschicht kann größer oder gleich 5%, insbesondere größer oder gleich 10 % betragen.

Das Bauteil kann eine Lauf - oder Leitschaufel einer Niederdruckturbine einer Gasturbine oder eines Flugtriebwerks ist, insbesondere eine Laufschaufel der zweiten oder dritten Stufe einer Niederdruckturbine, da die Erfindung auf diese Anwendung optimiert ist. Insbesondere kann es sich um Laufschaufeln eines sogenannten GTF (geared Turbofan) - Triebwerks handeln, bei dem die Niederdruckturbine über ein Getriebe mit dem Fan gekoppelt ist und somit die Laufschaufeln in der Niederdruckturbine mit hohen Drehzahlen von beispielsweise mehr als 10 000 Umdrehungen pro Minute betrieben werden.

Das entsprechende Bauteil in Form einer Lauf - oder Leitschaufel einer Gasturbine oder eines Flugtriebwerks kann vollständig an der gesamten Oberfläche, also sowohl im Blattbereich als auch im Fußbereich beschichtet werden, wobei dadurch zum einen der Beschichtungsaufwand durch nicht erforderliche Abdeckungen reduziert werden kann und zudem auch der Schaufelfuß vor Heißgaskorrosion und insbesondere Sulfidation geschützt werden kann.

Das Bauteil kann bei einer Einsatztemperatur von kurzzeitig bis maximal 850° C und für den Dauerbetrieb unter 800° C eingesetzt werden, wobei der kurzzeitige Betrieb bis zu 10 % der Gesamtbetriebsdauer ausmachen kann.

Nach einem weiteren Aspekt der Erfindung, für den selbstständig und in Kombination mit anderen Aspekten der Erfindung Schutz begehrt wird, wird ein Verfahren zur Herstellung eines Bauteils aus einer Nickelbasissuperlegierung für den Heißgaskanal einer Strömungsmaschine beansprucht, wobei das Verfahren die Schritte insbesondere in der angegebenen Reihenfolge umfasst: Bereitstellen eines Halbzeugs aus einer Nickelbasissuperlegierung,
Abscheiden von Ni und Cr oder Ni und Cr enthaltenden Legierungen oder Zusammensetzungen auf zumindest einem Teil des Halbzeugs durch chemische (CVD) oder physikalische (PVD) Dampfphasenabscheidung oder durch galvanische Abscheidung oder durch Streichen oder Lackieren zur Bildung einer Schutzschicht gegen Oxidation und Heißgaskorrosion und Diffusionsglühen des Bauteils im Temperaturbereich zwischen 900° C und 1150° C für 1 bis 10 h.

Das Abscheiden von Ni und Cr oder Ni und Cr enthaltenden Legierungen oder Zusammensetzungen kann kontinuierlich und / oder stufenweise mit unterschiedlichen Anteilen an Ni und / oder Cr erfolgen, insbesondere um Teilschichten auszubilden. So kann beim Abscheiden einer äußeren Teilschicht der Cr - Anteil erhöht und / oder Al mit abgeschieden werden.

Es können auch verschiedene Methoden zur Abscheidung der Schutzschicht kombiniert werden, insbesondere kann nach dem Abscheiden durch CVD - oder PVD - Verfahren oder durch galvanische Abscheidung ein Lack mit Al - Pigmenten zur Bildung einer äußeren Schicht mit Al - Anteilen aufgebracht werden.

### KURZBESCHREIBUNG DER FIGUREN

Die beigefügten Zeichnungen zeigen in rein schematischer Weise in
- Figur 1: einen teilweisen Querschnitt durch eine erste Ausführungsform eines erfindungsgemäßen Bauteils und in
- Figur 2: einen teilweisen Querschnitt durch eine zweite Ausführungsform eines erfindungsgemäßen Bauteils.

### AUSFÜHRUNGSBEISPIELE

Weitere Vorteile, Kennzeichen und Merkmale der vorliegenden Erfindung werden bei der nachfolgenden detaillierten Beschreibung der Ausführungsbeispiele ersichtlich. Allerdings ist die Erfindung nicht auf diese Ausführungsbeispiele beschränkt.

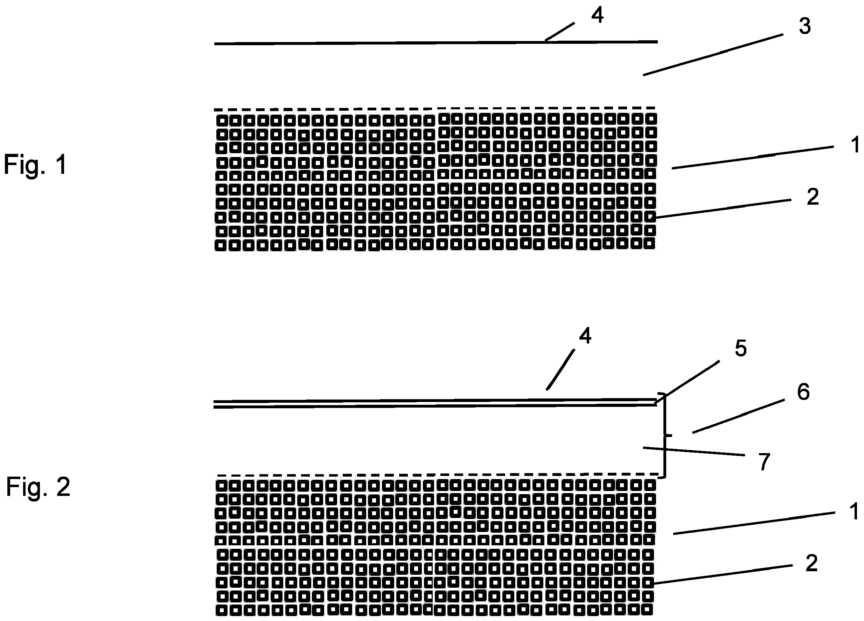

Die Figur 1 zeigt eine erste Ausführungsform eines erfindungsgemäßen Bauteils mit einer einschichtigen Schutzbeschichtung 3 auf dem Grundwerkstoff 1 des Bauteils. Der Grundwerkstoff 1 des Bauteils ist durch eine Nickelbasissuperlegierung gebildet, die eine Matrix aus γ - Nickel - Mischkristall aufweist, in welche γ '- Ausscheidungen der Zusammensetzung Ni(Ti,Al)₃ eingelagert sind. Der γ - Nickel - Mischkristall weist Anteile von Aluminium und / oder Titan im Mischkristall auf.

Gemäß dem Ausführungsbeispiel der Figur 1 ist nach einer erfindungsgemäßen Abscheidung von Nickel und Chrom eine einschichtige Schutzschicht 3 auf dem Grundwerkstoff 1 des Bauteils angeordnet, die aus kubisch flächenzentriertem γ - Nickel - Mischkristall besteht, in den Chrom eingelagert ist. Durch den kubisch flächenzentrierten γ - Nickel - Mischkristall besitzt die Schutzschicht ausreichende Duktilität, während der Chrom - Anteil die Korrosions - und Oxidationsbeständigkeit gewährleistet.

Die Schutzschicht 3 schließt das Bauteil gegenüber der Umgebung ab und bildet zumindest teilweise die Oberfläche 4 des Bauteils.

In der Figur 2 ist eine weitere Ausführungsform der Erfindung gezeigt, wobei wiederum ein Bauteil aus einer Nickelbasissuperlegierung vorgesehen ist, wobei der Grundwerkstoff 1 des Bauteils wiederum durch eine Nickelbasissuperlegierung gebildet ist, die eine Matrix aus γ - Nickel - Mischkristall aufweist, in welche γ '- Ausscheidungen der Zusammensetzung Ni(Ti,Al)₃ eingelagert sind. Der γ - Nickel - Mischkristall weist ebenfalls Anteile von Aluminium und / oder Titan im Mischkristall auf.

Das Ausführungsbeispiel der Figur 2 unterscheidet sich von dem der Figur 1 dadurch, dass die Schutzschicht 6 nicht nur aus einer einzelnen Schicht besteht, wie bei der Schutzschicht 3 der Ausführungsform gemäß Figur 1, sondern aus mindestens zwei einzelnen Teilschichten 5, 7.

Die innere Teilschicht 7, die also unmittelbar auf dem Grundwerkstoff 1 des Bauteils angeordnet ist, entspricht von ihrem Aufbau im Wesentlichen der Schutzschicht 3 des Ausführungsbeispiels der Figur 1, sodass sie aus kubisch flächenzentriertem γ - Nickel - Mischkristall besteht, in den Chrom eingelagert ist.

Allerdings weist die zweischichtige Schutzschicht 6 weiterhin eine äußere Teilschicht 5 auf, die einen höheren Chrom - Anteil aufweist und neben γ - Nickel - Mischkristallen α - Chrom - Mischkristalle umfasst. Die äußere Teilschicht bildet zumindest teilweise die Oberfläche 4 des Bauteils. Durch den höheren Cr - Anteil in der Randschicht ergibt sich ein besseres Korrosions - und Oxiadationsverhalten, während die Anwesenheit der kubisch raumzentrierten α - Chrom - Mischkristalle auf Grund der geringen Schichtdicke keine oder nur geringfügige Auswirkungen auf die Bruch - oder Risszähigkeit der gesamten Schutzschicht hat.

Obwohl die vorliegende Erfindung anhand der Ausführungsbeispiele detailliert beschrieben worden ist, ist für den Fachmann selbstverständlich, dass die Erfindung nicht auf diese Ausführungsbeispiele beschränkt ist, sondern dass vielmehr Abwandlungen in der Weise möglich sind, dass einzelne Merkmale weggelassen oder andersartige Kombinationen von Merkmalen verwirklicht werden können, ohne dass der Schutzbereich der beigefügten Ansprüche verlassen wird. Insbesondere schließt die vorliegende Offenbarung sämtliche Kombinationen der in den verschiedenen Ausführungsbeispielen gezeigten Einzelmerkmale mit ein, sodass einzelne Merkmale, die nur in Zusammenhang mit einem Ausführungsbeispiel beschrieben sind, auch bei anderen Ausführungsbeispielen oder nicht explizit dargestellten Kombinationen von Einzelmerkmalen eingesetzt werden können.

### BEZUGSZEICHENLISTE

- 1: Grundwerkstoff des Bauteils
- 2: γ'- Ausscheidungen
- 3: einschichtige Schutzschicht
- 4: Oberfläche
- 5: äußere Teilschicht der zweischichtigen Schutzschicht
- 6: zweischichtige Schutzschicht
- 7: innere Teilschicht der zweischichtigen Schutzschicht

## Patentansprüche

1. Bauteil für den Heißgaskanal einer Strömungsmaschine, wobei das Bauteil aus einer Nickelbasissuperlegierung mit einer Schutzschicht (3,6) gegen Oxidation und Heißgaskorrosion gebildet ist,
**dadurch gekennzeichnet, dass**
die Schutzschicht (3,6) γ - Nickel - Mischkristall - Phase aufweist und gemittelt über der Schutzschicht 45 bis 85 Gew.% Ni und 15 bis 55 Gew.% Cr umfasst sowie eine Dicke von 5 bis 80 µm aufweist.

2. Bauteil nach Anspruch 1,
**dadurch gekennzeichnet, dass**
die Schutzschicht oder eine inneren Teilschicht (7) der Schutzschicht 70 bis 85 Gew.% Ni und 15 bis 30 Gew.% Cr, insbesondere 75 bis 80 Gew. % Ni und 20 bis 25 Gew. % Cr umfasst, wobei sich die Anteile an Nickel und Chrom zu 100% ergänzen oder die Schutzschicht Ni und Cr enthaltende Legierungen oder Zusammensetzungen mit 15 bis 30 Gew.% Cr, vorzugsweise 20 bis 25 Gew. % Cr und Rest Nickel umfasst.

3. Bauteil nach einem der vorhergehenden Ansprüche,
**dadurch gekennzeichnet, dass**
die Schutzschicht (6) in einer äußeren Teilschicht (5) über 40 Gew.% Cr und vorzugsweise bis zu 24 Gew.% Al, insbesondere bis zu 10 oder 15 Gew.% Al aufweist.

4. Bauteil nach einem der vorhergehenden Ansprüche,
**dadurch gekennzeichnet, dass**
die Schutzschicht (6) in einer inneren Teilschicht (7) oder in der gesamten Schutzschicht (3) kein Aluminium aufweist.

5. Bauteil nach einem der vorhergehenden Ansprüche,
**dadurch gekennzeichnet, dass**
die Schutzschicht (3,6) eine mittlere Dicke von 15 bis 30 µm aufweist, wobei insbesondere eine äußere Teilschicht (5) mit höherem Cr - Gehalt eine Dicke von bis zu 10 µm, insbesondere eine mittlere Dicke von 1 bis 3 µm aufweist.

6. Bauteil nach einem der vorhergehenden Ansprüche,
**dadurch gekennzeichnet, dass**
die Schutzschicht (3,6) in zumindest einer Teilschicht (7) vollständig als kubisch flächenzentrierter γ - Nickel - Mischkristall ausgebildet ist.

7. Bauteil nach einem der vorhergehenden Ansprüche,
**dadurch gekennzeichnet, dass**
die Schutzschicht (6) zumindest teilweise in einem kubisch raumzentrierten Metallgitter, vorzugsweise in zumindest einer Teilschicht (5) zumindest teilweise als kubisch raumzentrierte α - Chrom - Phase ausgebildet ist.

8. Bauteil nach einem der vorhergehenden Ansprüche,
**dadurch gekennzeichnet, dass**
das Bauteil im Querschnitt von außen nach innen entweder eine Schutzschicht (6) mit einer Teilschicht (5) aus α - Chrom - Phase mit γ - Nickel - Mischkristall mit im Mischkristall aufgenommenem Chrom und / oder Aluminium und einer Teilschicht (7) aus γ - Nickel - Mischkristall sowie eine anschließende Zone entsprechend der Nickelbasissuperlegierung mit einem kubisch-flächenzentriertem Ni - Mischkristall mit ausgeschiedenen kohärenten γ' - Partikeln der Zusammensetzung Ni(Al,Ti)₃ aufweist oder eine Schutzschicht (3) aus γ - Nickel - Mischkristall mit im Mischkristall aufgenommenem Chrom sowie eine anschließende Zone entsprechend der Nickelbasissuperlegierung mit einem kubisch-flächenzentriertem Ni - Mischkristall mit ausgeschiedenen kohärenten γ' - Partikeln der Zusammensetzung Ni(Al,Ti)₃ aufweist.

9. Bauteil nach einem der vorhergehenden Ansprüche,
**dadurch gekennzeichnet, dass**
die Bruchdehnung der Schutzschicht größer oder gleich 5%, insbesondere größer oder gleich 10 % beträgt.

10. Bauteil nach einem der vorhergehenden Ansprüche,
**dadurch gekennzeichnet, dass**
das Bauteil eine Lauf - oder Leitschaufel einer Gasturbine oder eines Flugtriebwerks ist, insbesondere eine Laufschaufel der zweiten oder dritten Stufe einer Turbinenstufe, insbesondere einer Niederdruckturbine, vorzugsweise eine Laufschaufel eines GTF (geared Turbofan) - Triebwerks, wobei die Lauf - oder Leitschaufel vorzugsweise im Blatt - und Fußbereich der Schaufel, insbesondere vollflächig beschichtet ist.

11. Bauteil nach einem der vorhergehenden Ansprüche,
**dadurch gekennzeichnet, dass**
das Bauteil ausgebildet ist für den Einsatz bei einer Einsatztemperatur von kurzzeitig bis maximal 850° C und für den Dauerbetrieb unter 800° C.

12. Verfahren zur Herstellung eines Bauteils aus einer Nickelbasissuperlegierung für den Heißgaskanal einer Strömungsmaschine, insbesondere eines Bauteils nach einem der Ansprüche 1 bis 12, wobei das Verfahren die Schritte insbesondere in der angegebenen Reihenfolge umfasst:
Bereitstellen eines Halbzeugs aus einer Nickelbasissuperlegierung,
Abscheiden von Ni und Cr oder Ni und Cr enthaltenden Legierungen oder Zusammensetzungen auf zumindest einem Teil des Halbzeugs durch chemische (CVD) oder physikalische (PVD) Dampfphasenabscheidung oder durch galvanische Abscheidung oder durch Streichen oder Lackieren zur Bildung einer Schutzschicht gegen Oxidation und Heißgaskorrosion und
Diffusionsglühen des Bauteils im Temperaturbereich zwischen 900° C und 1150° C für 1 bis 10 h.

13. Verfahren nach Anspruch 12,
**dadurch gekennzeichnet, dass**
Abscheiden von Ni und Cr oder Ni und Cr enthaltenden Legierungen oder Zusammensetzungen kontinuierlich und / oder stufenweise mit unterschiedlichen Anteilen an Ni und / oder Cr erfolgt, um Teilschichten auszubilden.

14. Verfahren nach Anspruch 12 oder 13,
**dadurch gekennzeichnet, dass**
beim Abscheiden einer äußeren Teilschicht der Cr - Anteil erhöht und / oder Al mit abgeschieden wird.

15. Verfahren nach einem der Ansprüche 12 bis 14,
**dadurch gekennzeichnet, dass**
verschiedene Methoden zur Abscheidung der Schutzschicht kombiniert werden, insbesondere dass nach dem Abscheiden durch CVD - oder PVD - Verfahren oder durch galvanische Abscheidung ein Lack mit Al - Pigmenten zur Bildung einer äußeren Schicht mit Al - Anteilen aufgebracht wird.
